**Europäisches Patentamt**

(19) **European Patent Office**

**Office européen des brevets**

(11) Veröffentlichungsnummer: **0 002 703**
**B1**

(12) **EUROPÄISCHE PATENTSCHRIFT**

(45) Veröffentlichungstag der Patentschrift: **30.09.81**

(21) Anmeldenummer: **78101608.4**

(22) Anmeldetag: **08.12.78**

(51) Int. Cl.³: **H 01 B 5/14, H 05 K 3/02, H 01 L 29/46, H 01 L 21/28**

(54) Verfahren zum Herstellen von dünnen metallisch leitenden Streifen auf Halbleitersubstraten und damit hergestellte metallisch leitende Streifen.

(30) Priorität: **30.12.77 US 865810**

(43) Veröffentlichungstag der Anmeldung:
**11.07.79 Patentblatt 79/14**

(45) Bekanntmachung des Hinweises auf die Patenterteilung:
**30.09.81 Patentblatt 81/39**

(84) Benannte Vertragsstaaten:
**DE FR GB**

(56) Entgegenhaltungen:
**DE - A - 1 924 845**
**DE - A - 2 104 672**
**DE - A - 2 647 566**
**DE - A - 2 734 072**
**DE - C - 1 105 067**
**US - A - 3 893 160**

**IBM — TECHNICAL DISCLOSURE BULLETIN**
**Vol. 15, No. 4**
**September 1972, Seite 1088**

(73) Patentinhaber: **International Business Machines Corporation**
**Armonk, N.Y. 10504 (US)**

(72) Erfinder: **Gangulee, Amitava**
**20 Mount Greed Road**
**Croton-On-Hudson NY 10520 (US)**
Erfinder: **Ho, Paul Siu-Chung**
**21 Old Mill Road**
**Chappaqua NY 10514 (US)**
Erfinder: **Howard, James Kent**
**Cedar Hill Road**
**Fishkill NY 12524 (US)**

(74) Vertreter: **Böhmer, Hans Erich, Dipl.-Ing.**
**Schönaicher Strasse 220**
**D-7030 Böblingen (DE)**

Courier Press, Leamington Spa, England.

Verfahren zum Herstellen von dünnen metallisch leitenden Streifen auf Halbleitersubstraten und damit hergestellte metallisch leitende Streifen

Verfahren zum Herstellen von schmalen, intermetallischen Leiterstreifen aus mindestens einer Zone eines gut leitenden Metalls und einer Zone einer intermetallischen Verbindung dieses gut leitenden Metalls durch Aufdampfen des Metalls und des Übergangsmetalls auf ein Substrat in einem sauerstoffreien Vakuum von weniger als etwa $1,333 \times 10^{-5}$ mbar, Anlassen dieser Schicht bei einer zwischen 200° C und 500° C liegenden Temperatur so lange, bis sich in der Schicht mindestens eine Zone einer Metall-Übergangsmetallverbindung gebildet hat, und Bilden der Leiterstreifen durch Maskieren und Entfernen von Teilen der Schicht.

Beschreibung des Standes der Technik

Seit einigen Jahren hat man in der Halbleitertechnik und bei der Herstellung von integrierten Schaltungen dünne, schmale, leitende Schichten oder Streifen als Verbindungsleitungen benuzt. Ähnliche Arten von Leiterstreifen werden auch bei Magnetblasenspeichern verwendet. Bei ständig geringer werdenden Abmessungen derartiger Vorrichtungen müssen auch die Abmessungen der elektrisch leitenden Streifen verringert werden. Dies hat zur Folge gehabt, daß sich die Stromdichte in derartigen Leiterstreifen entsprechend erhöht hat. Bei den höheren Stromdichten in diesen Streifen gibt es jedoch Ausfallerscheinungen durch Elektromigration, was eine ins Gewicht fallende Beschränkung der Zuverlässigkeit derartiger Schaltungen mit sich bringt.

Die Größe der Elektromigration ist dabei eine Funktion der Temperatur und der Stromdichte. Im allgemeinen hat die Elektromigration bei Stromdichten unterhalb von $10^4$ Ampere/cm$^2$ nu einen geringen Einfluß auf die Lebensdauer eines Leiterstreifens. Wenn jedoch Stromdichten von etwa $10^5$ Ampere/cm$^2$ oder höher gewählt werden, dann kann die Elektromigration die Hauptursache für Ausfallerscheinungen sein.

Die Elektromigration tritt auf, wenn ein Leiter auf einer erhöhten Temperatur gehalten wird und der Strom einen Stofftransport in dem Leiter verursacht. Dieser durch den Strom verursachte Stofftransport ergibt sich aus einer Kombination der Wirkungen des unmittelbaren Impulsaustausches zwischen den sich bewegenden Elektronen und dem Einfluß eines angelegten elektrischen Feldes. Durch den Strom verursachter Stofftransport bewirkt, daß Material von einer oder mehreren Stellen des Leiterstreifens abgetragen und an anderen Stellen des Leiterstreifens Material niedergeschlagen oder abgelagert wird. Dies kann eine Stromkreisunterbrechung dort zur Folge haben, wo das Material entfernt wird und einen Kurzschluß dort, wo das Material niedergeschlagen wird. Elektromigration kann in Halbleitervorrichtungen dann noch zusätzliche Schwierigkeiten verursachen, wenn die Halbleitervorrichtung mit einer Passivierungsschicht aus Glas, Silicium-Nitrid oder Siliciumdioxid überzogen ist. Diese Schicht kann als Folge dieser Materialwanderung aufreißen. Durch dieses Aufreißen können aber einzelne Bauelemente einer atmosphärischen Korrosion ausgesetzt werden.

Es ist bekannt, daß die Elektromigration in aus Aluminium, Gold, Kupfer und Silber besehenden Leitern auftritt. Man hat die Elektromigration in Aluminium dadurch verringert, daß man entweder eine Aluminium-Legierung verwendete oder indem man Schichtenleiter aufbaute. Bei Aluminium-Leitern hat man bei der Verringerung der Elektromigraiton bereits wesentliche Fortschritte erzielt, wie dies beispielsweise der DE—A— 26 47 566 der Anmelderin entnommen werden kann. In dieser Patentanmeldung ist auch eine Zusammenfassung früherer Entwicklungsarbeiten enthalten, die zu einer Verringerung der Elektromigration in Aluminium-Leitern führten.

In der DE—A— 20 01 516 der Anmelderin ist die Lehre offenbart, daß durch geringfügige Beigaben von Kupfer zur leigierung von Aluminium-Streifenleitern der Widerstand dieser Streifenleiter gegen Elektromigration wesentlich erhöht werden kann.

Bei der Herstellung mehrschichtiger Aluminium-Streifen offenbart die oben genannte DE—A—26 47 566.1 eine wirksame Möglichkeit, zusammengesetzte Streifenleiter aus Aluminium it dazwischen liegenden Schichten eines Übergangsmetalls herzustellen, die die zur Bildung ebener Schichten einer in das Aluminium hineinwachsenden Verbindung einer Wärmebehandlung ausgesetzt werden. Jeder sich dabei ergebende Streifenleiter würde Schichten aus sehr gut leitendem Aluminium mit dazwischen liegenden Schichten einer Aluminium-Verbindung mit einem hohen Widerstand gegen Elektromigration aufweisen, so daß insegesamt durch diese Wärmebehandlung das Betriebsverhalten des Streifenleiters verbessert würde. Dabei wird angegeben, daß hochstabile Aluminium-Verbindungen wie $HfAl_3$ und $TaAl_3$ auf die Lebensdauerererwartung solcher Streifenleiter keine so große Wirkung ausüben, wie die weniger stabilen Verbindungen, da die sehr stabilen Verbindungen sich vorzugsweise an den Korngrenzen bilden, statt laminare Verbindungen der transgranularen Art.

Die Fortschritte bei der Erhöhung des Elektromigrationswiderstandes waren beträchtlich, und man kann heute Aluminium-Streifen vor einer Zerstörung durch Elektromigration bei Stromdichten bis zu $10^6$ Ampere/cm$^2$ und bei Betriebstemperaturen von 85°C zu schützen. Es muß jedoch damit gerechnet werden, daß kleinere Vorrichtungen und Magnetblasenspeicher bei Stromdichten von mehr als $10^7$ Ampere/cm² und bei Temperaturen in der Gegend von 100°C betrieben werden.

Um die zukünftigen anforderungen an Streifenleiter zu erfüllen, wurden andere Grundmetalle als Aluminium untersucht, und Gold scheint dabei die besten Aussichten zu haben. Der Elektromigrationswiderstand von reinem Gold ist höher als der von reinem Aluminium. Diese Tatsache ist in einem Aufsatz von J. C. Blair u.a. in Journal Applied Physics, Band 43, Nr. 2, Seiten 307—311 (Februar 1972) mit dem Titel "Electromigration-Induced Failures in, and Microstructure and Resistivity of, sputtered Gold Films" dargelegt. Ferner wird durch P. Ho u.a. in einem Aufsatz mit dem Titel "Implications of Electromigration on Device Reliability", welcher in dem Buch "Electro- and Thermo-Transport in Metals and Alloys" der Metallurgical Society, Seiten 108—188 (1977), New York, enthalten ist, berichtet, daß durch Goldlegierungen und Herstellung von Schichtenleitern der Elektromigrationswiderstand der sich ergebenden Leiter erhöht werden kann.

Geschichtete Leiterstrukturen werden für ohmsche Kontakte und für Leiterstreifen vorgeschlagen. In der US—A— 3 419 765 sind mehrschichtige ohmsche Kontakte beschrieben, die aus einer Schichtenfolge von Aluminium-Nickel-Gold-Nickel bestehen. Der Sinn dieser geschichteten Struktur besteht darin, zwischen den Aluminium- und Gold-Drähten die Bildung einer $AuAl_2$-Verbindung zu verhindern. Die US—A— 3 893 160 offenbart eine geschichtete Struktur aus Platinsilicid-Titan-Molybdän-Gold als Kontaktmaterial, doch diese beiden Patentschriften sagen nichts über eine Wärmebehandlung dieser Schichtenstrukturen zur Bildung inter-metallischer Verbindungen aus. In der DE—A— 21 04 672 der Anmelderin ist die Verwendung einer aus Tantal-Gold-Tantal bestehenden Schichtenfolge für einen Streifenleiter offenbart, doch enthält diese Patentanmeldung keinen Hinweis auf eine Wärmebehandlung solcher Streifen zur Bildung intermetallischer Verbindungen.

Ein Aufsatz von A. Gangulee u.a mit dem Titel "The Activation Energy for Electromigration and Grain-Boundary Self-diffusion in Gold" aus "Scripta Meta", Band 7, Seiten 1027—1030 (1973) offenbart die Wärmebehandlung einer aus Permalloy-Gold-Permalloy bestehenden Schichtenstruktur, offenbart jedoch keine Wärmebehandlung dieser Streifen zur Bildung intermetallischer Verbindungen. Die US—A— 3 715 234 offenbart die Verwendung eines wärmebehandelten Kontaktmaterials, das aus einer Anzahl interdiffundierter Schichten aus Antimon, Gold, Phosphor und Gold besteht. Diesem Stand der Technik ist keine Offenbarung und keine Lehre dahin-gehend zu entnehmen, eine Material aus abwechselnden Schichten aus Gold ausreichender Reinheit für einen geringen elektrischen Widerstand mit dazwischen liegenden intermetallischen Goldverbindungen offenbart, die der elektromigration widerstehen. Außerdem enthält der Stand der Technik kein Verfahren zur Erzeugung einer solchen Struktur in Goldlegierungen.

Aufgabe der Erfindung ist es also, einen verbesserten, Gold enthaltenden Leiterstreifen mit verbessertem Elektromigrationswiderstand zu schaffen, sowie ein Verfahren anzugeben, mit dem ein solcher Leiterstreifen hergestellt werden kann.

Gesamtdarstellung der Erfindung

Gemäß der vorliegenden Erfindung kann ein verbessertes Betriebsverhalten bezüglich Elektromigration für sehr schmale Leitungen oder Streifenleiter ohne wesentliche Erhöhung des Widerstandes der leitenden Streifen durch entsprechende Herstellung von intermetallischen Schichten in auf Gold basierenden dünnen Schichten erreicht werden. Die stromführenden Leiterstreifen, deren Breite 0,015 mm oder weniger beträgt und die von einem Substrat getragen werden, enthalten Gold und mindestens einen Bereich innerhalb des von aus Gold bestehenden Streifens aus einer intermetallischen Verbindung von Gold un einem Übergangsmetall aus der Niob, Zirkon und Hafnium enthaltenden Gruppe.

Diese Vorteile ergeben sich insbesondere bei einer Schichtenfolge des Leiterstreifens, bei der auf dem Substrat zunächst eine Schicht aus einem ausgewählten Übergangsmetall angebracht ist, über der dann die aus Gold bestehende Leiterschicht liegt, und über der gegebenenfalls eine oder mehrere Schichten folgen können, wobei die nächstfolgende Schicht wiederum aus dem ausgewählten Übergangsmetall besteht.

Die der Erfindung zugrunde liegende Aufgabe wird bei einem Verfahren der eingangs inämnten Art dadurch gelöst, daß auf das Substrat (51) eine Schicht (56) eines Übergangsmetalls aus der Zirkon, Niob und Hafium enthaltenden Gruppe und darüber als Leiterschicht (58) eine aus Gold bestehende Schicht aufgebracht werden.

Die Erfindung wird nunmehr anhand einer Ausführungsform der Erfindung in Verbindung mit den beigefügten Zeichnungen im einzelnen näher beschrieben.

In den Zeichnungen zeigt
Fig. 1 eine perspektivische Ansicht eines Leiterstreifens auf einem Substrat,
Fig. 2 eine stark vergrößerte, schematische Querschnittsansicht eines Aluminium Leiterstreifens gemäß dem Stande der Technik,
Fig. 3 eine stark vergrößerte, schematische Querschnittsansicht eines anderen Aluminium-Leiterstreifens gemäß dem Stande der Technik und
Fig. 4 eine stark vergrößerte, schematische Querschnittsansicht einer Ausführungsform eines Gold-Leiterstreifens gemäß der Erfindung.

Beschreibung der bevorzugten Ausführungsform

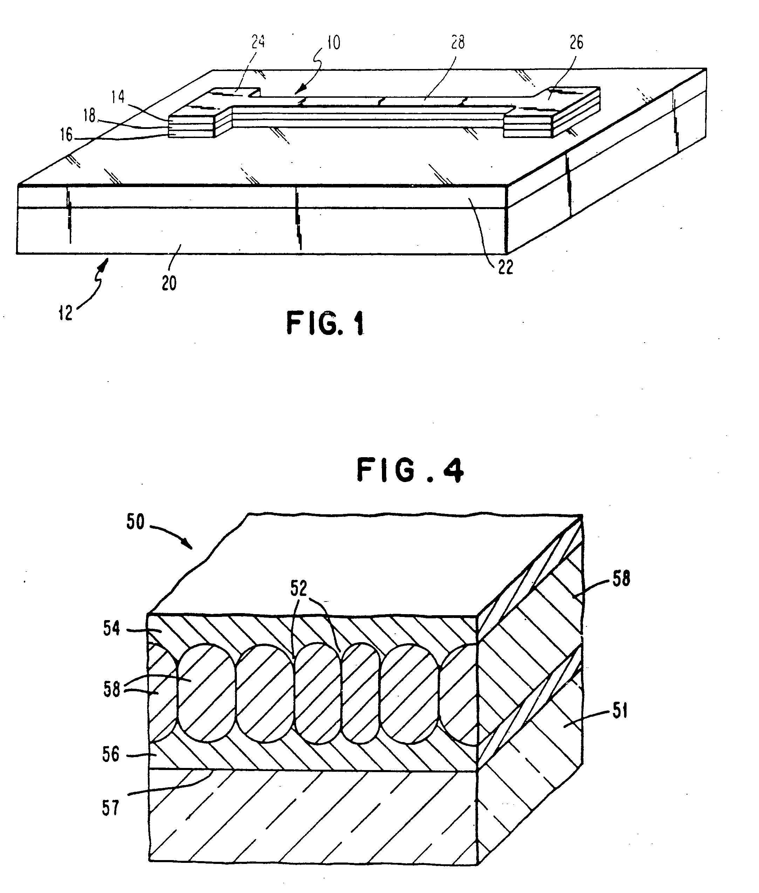

Fig. 1 zeigt einen aus Gold bestehenden Leiterstreifen 10, dessen Breite weniger als 0,015 mm beträgt. Der aus Gold bestehende Leiterstreifen wird von einem Substrat 12 getragen und besteht aus drei Schichten. Die oberste Schicht 14 und die unten liegende Schicht 16 bestehen aus einer intermetallischen Verbindung und vorzugsweise, jedoch nicht notwendigerweise, einer Schicht eines nicht umgesetzten Übergangsmetalls aus der Niob, Zirkon und Hafnium enthaltenden Gruppe. Die Mittelschicht 18 besteht praktisch aus Gold. Dies ist eine bevorzugte Anordnung für den Leiterstreifen 10. Eine weitere vorteilhafte Anordnung ist ein aus zwei Schichten bestehender Leiterstreifen, wobei die Verbindung die unten liegende Schicht des Leiterstreifens 10 bildet. Das Substrat 12, auf dem der aus Gold bestehende Leiterstreifen 10 angeordnet ist, kann irgendeines der gewünschten Substrate sein, bei dem sehr dünne leitende Streifen Verwendung finden können. Ein Beispiel dafür ist ein Halbleitersubstrat, in dem eine Anzahl von Transistoren, Dioden, ladungsgekoppelter Vorrichtungen, Widerstände, Kondensatoren und dergleichen angeordnet ist. Bei dieser Art Ausführungsform würde das Substrat 20 aus Silicium bestehen und wäre einer Siliciumdioxid-Schicht 22 überzogen. Der aus Gold bestehende Leiterstreifen 10, der aus vergrößerten Kontaktbereichen 24 und 26 und einem sehr dünnen, dazwischen liegenden Streifen 28 besteht, liegt auf der das Substrat 20 überziehenden Siliciumdioxid-Schicht 22.

Ein weiteres wichtiges Anwendungsgebiet für sehr dünne Leiterstreifen gemäß Fig. 1 sind Magnetblasenspeicher. Bei dieser Art von Vorrichtung wäre das Substrat 20 aus einem Granatmaterial, das einen Metalloxid-Überzug, der ein Siliciumdioxid-Überzug 22 sein könnte, trägt und der Leiterstreifen 10 könnte darauf gebildet werden. Wie bereits erläutert, kann der Leiterstreifen gemäß der Erfindung wesentlich höhere Stromdichten aushalten, als ein aus Aluminium bestehender Leiterstreifen, ohne daß damit der Widerstand gegen Elektromigration verloren geht. Diese höheren Stromdichten sind aber bei der Herstellung von Magnetblasenspeichern erforderlich. Außerdem enthalten diese Leiterstreifen keine ferromagnetischen Materialien, die bei Magnetblasenspeichern unerwünscht wären.

Die gesamte Dicke der dünnen, aus Gold bestehenden Schicht in dem Teststreifen beträgt zwischen 0,1 $\mu$m und 1,5 $\mu$m. Der leitende Streifen 28 ohne die Kontaktbereiche 24 und 26 ist dabei weniger als 0,015 mm breit, und die Länge ist im allgemeinen mit der Breite vergleichbar oder größer. Die Ecken, wo der Leiterstreifen in die Kontaktbereiche 24, 26 übergeht, sind abgerundet, um damit die Möglichkeit von durch Elektromigration hervorgerufenen Ausfallerscheinungen so klein wie möglich zu machen. Die Kontaktbereiche 24 und 26 sind im Vergleiche mit dem Leiterstreifen relativ groß, haben aber die gleiche Dicke wie der Leiterstreifen.

Es gibt tatsächlich einen optimalen Bereich zwischen der gewünschten Elektromigrations-Lebensdauer und dem spezifischen Widerstand des Leiterstreifens. Mit zunehmender Menge am Übergangsmetall wird der Widerstand des Leiterstreifens höher.

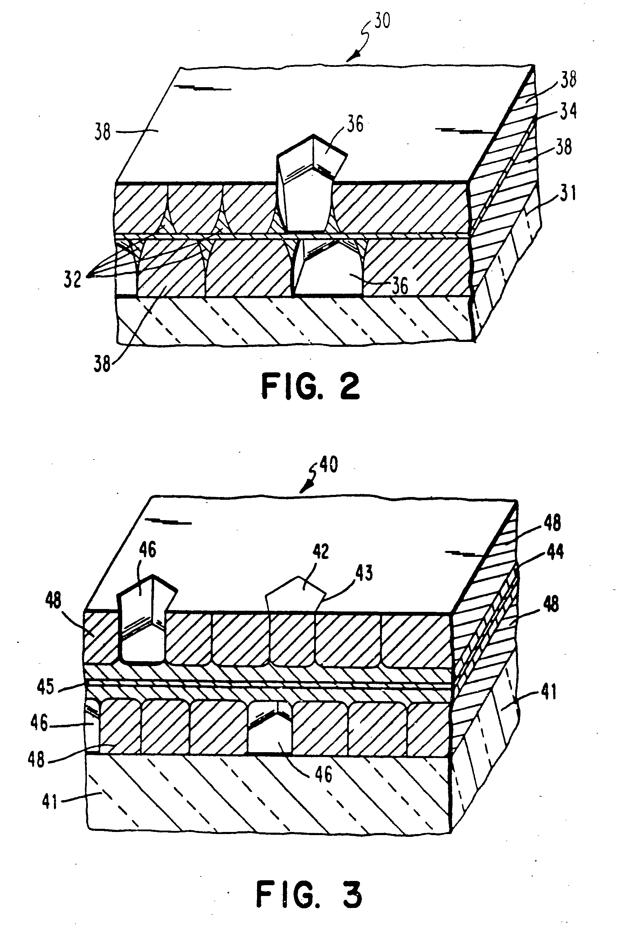

Die DE—A— 26 47 566, auf die bereits Bezug genommen wurde, offenbart die Verwendung von Chrom, Palladium, Nickel, Platin, Wolfram, Vanadium und Moylbdän in aus Aluminium bestehenden Streifen, da damit der Leiterstreifen eine höhere Lebensdauer erhält als mit Elementen wie Hafnium, Zirkon und Niob, die stabilere Verbindungen bilden. Die Erläuterung für diese Ergebnisse besteht darin, daß Metalle, die stabilere Verbindungen liefern, vorzugsweise längs der Korngrenzen diffundieren und damit eine ziemlich dünne Sperrschicht zwischen den in Fig. 2 gezeigten Aluminium-Schichten liefern. Der aus Aluminium bestehende Leiterstreifen 30 liegt auf einem Substrat 31. Wegen der beträchtlichen Diffusion längs der Korngrenzen ergibt sich eine bevorzugte Bildung einer Verbindung 32 längs der Korngrenze. Daraus bildet sich eine dünne Schicht 34 am Ort des ursprünglich vorhandenen Übergansmetalls und kann dazu führen, daß Hohlräume 36 (Lunker) in den aus Aluminium bestehenden Teilen 38 des Leiterstreifens 30 sich bilden. Fig. 3 andererseits zeigt eine Struktur, die sich aus der Verwendung von Metallen ergibt, die weniger stabile Verbindungen bilden. Der Leiterstreifen 40 wird von einem Substrat 41 getragen. Da die Wachstumsgeschwindigkeit der Verbindung in das Korn 42 hinein nahezu vergleichbar mit der Wachstumsgeschwindigkeit der Verbindung längs der Korngrenzen 43 ist, bildet sich eine ziemlich durchgehende Schicht 44 aus einer Übergangsmetall-Aluminium-Verbindung.

Vorzugsweise, jedoch nicht notwendigerweise, ist dabei eine nicht umgesetzte Schicht 45 des Übergangsmetalls vorhanden. Diese ziemlich gleichförmige Schicht verringert natürlich die Verbindung von Hohlräumen 46 oder Lunkern miteinander, die in den aus Aluminium bestehenden Teilen 48 des Leiterstreifens vorhanden sind.

Wie man aus diesen Beispielen des Standes der Technik erkennt, ist die Bildung einer Verbindung ein sehr komplexer Vorgang, der sich nicht mit Sicherheit vorher bestimmen läßt.

Diese bekannten Verfahren sind auf aus Aluminium bestehenden Leiterstreifen anwendbar, jedoch nicht auf aus Gold bestehende Leiterstreifen. Tatsächlich ergibt sich überraschender-weise dann, wenn man ein Metall, wie zum Beispiel Chrom oder Titan auswählt, das mit Gold eine Verbindung geringer Stabilität bildet, daß das Gold durch das Übergangsmetall vergiftet wird und daß die Leitfähigkeit des Goldes bis auf einen Grad verringert wird, der für die Verwendung als Leiterstreifen nicht annehmbar ist. Wenn man aber ein Übergangsmetall auswählt, das eine stabilere Goldverbindung liefert, dann wird der sich ergebende Streifenleiter die gewünschten elektrischen Eigenschaften aufweisen.

Es hat den Anschein, daß Störstoffe eines Übergangsmetalls eine größere Auswirkung bei der Erhöhung des spezifischen Widerstandes von Gold haben als von Aluminium. Aus diesem Grund ist es vorzuziehen, stabilere Verbindugen in aus Gold bestehenden Leiterstreifen herzustellen, um damit den Störstoffgehalt in der Goldmatrix gering zu halten, und dadurch auf die Legierungsbildung zurückzuführende Zunahme des spezifischen Widerstandes des Goldes klein zu halten

Tabelle I ziegt die Veränderungen in den elektrischen Eigenschaften, wenn die Leiterstreifen für 50 Stunden zur Bilduing der gewünschten Verbindugen auf 327°C erwärmt werden.

TABELLE I

Spezifischer Widerstand eines Gold-Leiterstreifens mit verschiedenen Metall-zusatzen und der spezifische Widerstand eines Streifens mit den zugehörigen Verbindungen

| Beigabe von Übergangsmetall | Spezifischer Widerstand $\mu\Omega$-cm von Gold | Spezifischer Widerstand, Zunahme $\mu\Omega$-cm der Gold-Verbindung | Prozentuale Änderung des spezifischen Widerstandes |
|---|---|---|---|
| Ti | 2.5 | 15.0 | 600 |
| Cr | 2.5 | 30.0 | 1200 |
| V | 2.5 | 80.0 | 3200 |
| Ta | 2.5 | 1.25 | 50 |
| Nb | 2.5 | 0.50—0.75 | 20—30 |
| Hf | 2.5 | 1.0 | 40 |
| Zr | 2.5 | 1.25 | 50 |

Es ist offensichtlich, daß die Änderungen des spezifischen widerstandes wirklich drastisch sind, wobei der spezifische Widerstand der warm behandelten Leiterstreifen in vielen Fällen größer ist als der wesentlich schlechtere Leiter, wie z.B. Eisen. Wenn Leiterstreifen, die Übergangsmetalle enthalten, die zur Bildung weniger stabilizer Verbindungen neigen, einer Wärmebehandlung unterzogen werden, dann hat der höhere Widerstand dieser Streifen zur Folge, daß sie nicht länger als für Leiter brauchbare Materialien angesehen werden können.

Diese Ergebnisse zeigen, daß die günstigste Mikrostruktur für aus Gold bestehende Leiterstreifen die wäre, bei de eine merkliches Eindringen der intermetallischen Phase an den Korngrenzen stattfindet, wie dies Fig. 4 zeigt.

Der Goldstreifen 50 wird von einem Substrat 51 getragen. die Bildung der Verbindung erfolgt bevorzugt längs der Korngrenzen 52. Dabei gibt es eine oben liegende Schicht 54 der Verbindung und eine unten liegende Schicht 56 der Verbindung. Die unten liegende Schicht 56 erhöht nicht nur den Elektromigrationswiderstand des Streifens, sondern benetzt die Substratoberfläche 57, wobei diese Benetzung zum Herstellen einer Verbindung zwischen dem Leiterstreifen und dem Substrat 51 notwendig ist. Da Gold an den meisten verwendeten Substraten nicht haftet, wird zwischen dem Substrat und aus Gold bestehenden Leiterstreifen eine Zwischenschicht benutzt. Häufig wird eine solche Zwischenschicht eine auf Eisengrundlage aufgebaute Legierung, wie z.B. Permalloy sein. Wenn jedoch diese Gold-Leiterstreifen bei Magnetblasenspeichern verwendet werden, können Eisenlegierungen nicht benutzt werden, da sie ferromagnetisch sind.

Es ist durchaus möglich, einen annehmbaren Leiterstreifen nur mit der unten liegenden intermetallischen Schicht 56 zu erhalten. Vorzugsweise wird man jedoch, wie in Fig. 4 gezeigt, eine untere und eine obere intermetallische Schicht 54 bzw. 56 verwenden. Bei dieser Ausführungsform ist jedes Korn praktisch von einer intermetallischen Hülle umgeben und Elektromigration ist stark verringert. Da die Dicke der Abscheidung an den Korngrenzen sehr gering ist, wird dadurch die Leitfähigkeit der Goldschicht 58 nicht wesentlich verringert.

Es muß darauf hingewiesen werden, daß zwar die Gold-Leiterstreifen in Verbindung mit zwei intermetallischen Schichten besprochen wu. den, daß jedoch auch mehr als zwei intermetallische Schichten benutzt werden können, wodurch die besten Eigenschaften zur Verhinderung der Elektromigration erzielt werden.

Die Korngröße bei derartigen vielschichtigen Leiterstreifen wird natürlich geringer sein, und die geringere Korngröße verringert natürlich die statistische Schwankung in der Lebenserwartung des Leiterstreifens. Außerdem wird die genaue Definition der Linien bei abnehmender Korngröße ebenso erhöht. Mit einem aus vielen Schichten bestehenden Leiterstreifen kann man einen gut definierten Leiterstreifen mit gleichförmigen Querschnitt erzeugen, wodurch dessen Zuverlässigkeit erhöht wird, da Schwankungen in den Stromdichten vermieden werden. Außerdem hat auf einer intermetallischen Schicht aufwachsendes Gold eine im hohen Maße bevorzugte Orientierung oder Ausrichtung oder Ausrichtung, die gewöhnlich <111> verläuft und bei vielschichtigen Anordnungen kann bis zu zwei Dritteln des Goldes die bevorzugte Ausrichtung besitzen. Dies ist insofern wichtig, als die Elektromigrationsgeschwindigkeit von Gold mit der Zunahme des Anteils der bevorzugten Ausrichtung abnimmt.

Hat man jedoch mehr als eine metallische Schicht, dann ergeben sich dadurch Schwierigkeiten, daß der spezifische Widerstand erhöht wird, wenn der Leiterstreifen mehr intermetallische Verbindungen enthält und das Herstellverfahren ist auch etwas schwieriger.

Das Verfahren zur Herstellung schmaler intermetallischer Leiterstreifen auf der Oberfläche eines Körpers, wie dies Fig. 1 zeigt, kann wie folgt durchgeführt werden.

Eine leitende Schicht kann auf einem selbsttragenden Substrat oder Körper niedergeschlagen werden. Das dabei angewandte Niederschlagsverfahren kann beispielsweise mit elektronenstrahl, Verdampfung eines Aufgeheizten .Drahtes, gleichzeitige Verdampfung beider Stoffe und Kathodenzerstäubung arbeiten. Diese Verfahren laufen gewöhnlich ohne Aufheizen des Substrats ab.

Wenn die dünnen Schichten auf das Substrat aufgedampft werden sollen, dann wird das Substrat in ein Verdampfungsgerät eingebracht, das mit einer Vakuumpumpe ausgepumpt wird. Das Auspumpen sollte ausreichend lange vorgenommen werden, damit die Innenwände des Verdampfungsgeräts möglichst gasfrei gemacht werden, um während der Verdampfung die Möglichkeit einer Sauerstoffvergiftung zu beseitigen. Eine Sauerstoffvergiftung in dem Leiterstreifen kann Schwierigkeiten verursachen, weil die Oxydation des Übergangsmetalls die Geschwindigkeit bei der Bildung der Verbindung verringern oder die Bildung einer Verbindung überhaupt verhindern kann, so daß auch die Wirkung einer Verbindungsschicht auf die Elektromigration verringert oder beseitigt wird.

Metallische Verdampfungsquellen für Gold und das Übergangsmetall sollten von hoher Reinheit sein mit einem Reinheitsgrad in der Größenordnung von 99,99+%. Das Verdampfungsgerät wird auf $1,333 \times 10^{-5}$ m bar ausgepumpt. Höhere Drücke sind wegen der möglichen Oxidvergiftung nicht zufriedenstellend, während geringer Drücke, vorzugsweise weniger als $6,6 \times 10^{-6}$ m bar durchaus erwünscht sind.

Das Gold und die Übergangsmetalle werden dann auf das Substrat aufgedampft. Es ist dabei vorzuziehen, zur Erzielung einer sehr feinen Kornstruktur das Übergangsmetall sehr langsam aufzudampfen. Die bevorzugten Aufdampfgeschwindigkeiten für das Übergangsmetall liegen zwischen etwa 0,002 n m je Sekunde bi etwa 2 n m je Sekunde. Die bevorzugten Aufdampfungsgeschwindigkeiten aus der Goldquelle liegen zwischen etwa 0,2 nm je Sekunde bis etwa 60 n m je Sekunde. Es ist selbstverständlich wichtig, daß auch das Gold eine feine Kornstruktur aufweist, da sicht damit eine bessere Definition des Leiter-streifens erzielen läßt und da außerdem die Geschwindigkeit der Bildung der Verbindung erhöht wird, wenn mehr Korngrenzen für die zwischen die Korngrenzen hinein erfolgende Diffusion zwischen Gold und dem Übergangsmetall zur Verfügung stehen.

Wenn zum Niederschlagen der dünnen Schichten auf einem Substrat Kathodenzerstäubung benutzt wird, dan besteht das bevorzugte Verfahren aus folgenden Verfahrensschritten: Das Substrat wird in eine Kammer eingebracht, die dann bis zu einem Druck von weniger als etwa $1,333 \times 10^{-6}$ m bar ausgepumpt wird, worauf die Kammer wiederum bis zu einem Druck zwischen etwa 10 und 50 Mikron mit einem inerten Gas gefüllt wird, worauf die Hochfrequenzzerstäubung mit einer Hochfrequenzspannung durchgeführt wird, die zwischen 500 und 2000 Volt bei einer Gleichvorspannung bis zu 20 Volt liegt. Die Niederschlagsgeschwindigkeiten sollten dabei zwischen 0,002 n m je Sekunde und 20 n m je Sekunde für das Übergangsmetall und zwischen 0,2 n m je Sekunde und 60 n m je Sekunde für das Gold liegen.

Zum Anlassen wird der Leiterstreifen auf eine Temperatur zwischen ewtwa 200°C und 525°C erwärmt, wobei die Temperatur solange aufrechterhalten wird, bis sich Verbindungen aus Gold und dem Übergangsmetall bilden. Vorzugsweise sollte diese Zeit zwischen etwa dem Bruchteil einer Stunde und 100 Stunden liegen. Temperaturen und Zeiten ändern sich natürlich entsprechend dem benutzten Übergangsmetall und der Art und Menge der zu bildenden Verbindung. Ganz allgemein ist jedoch zu sagen, daß die kürzeren Zeiten den höheren Anlaßtemperaturen zugeordnet sind.

Nachdem das Gold und die Übergangsmetalle auf das Substrat aufgedampft sind, wird vor oder nach dem Anlassen der dünnen Schicht die Herstellung der Leiterstreifen in der Weise durchgeführt, daß das überschüssige Metall entfernt wird. Dazu können an sich bekannte Verfahren, wie zum Beispiel Elektronenstrahl-Lithographie oder aber Ionenstrahl-Bearbeitung benutzt werden.

Im folgenden werden Beispiele von Testläufen gegeben. Die Vorbereitung der Proben sollen das Verständnis der Erfindung erleichtern. Dem Fachmann sind ohne weiteres Abweichungen davon möglich, ohne dabei vom Wesen und Anwendungsbereich der Erfindung abzuweichen.

Beispiel 1

Die zu beschichtenden Substrate waren Silicium-Scheiben mit einem Durchmesser von 25,4 mm. Die Scheiben hatten 500 nm dicke Überzüge aus Siliciumdioxid. Die Silicium-Scheiben wurden in die Kammer eines Verdampfungsgeräts eingesetzt. Das Verdampfungsgerät wurde mittels einer Vakuumpumpe für 16 Stunden ausgepumpt, um die Seitenwände zur Verhinderung der Möglichkeit einer Sauerstoffvergiftung während der nachfolgenden Verdampfung gasfrei zu machen. Die Gold- und Hafnium-Quellen wurden durch Verdampfung auf eine Blende entgast. Nach einem Auspumpvorgang von 16 Stunden betrug der Druck angenähert $1,333 \times 10^{-6}$ m bar. Anschließend wurde flüssiger Stickstoff zum Absenken des Druckes auf $2,666 \times 10^{-7}$ m bar eingeleitet. Während des Entgasens von Hafnium und Gold wurde eine Blende benutzt. Bei diesem Verfahren wurde praktisch der gesamte Sauerstoff gegettert, und schließlich wurde ein Druck von $9,331 \times 10^{-8}$ m bar erreicht. Ein Elektronenstrahl wurde auf eine Hafnium-Quelle entrichtet, und es wurde damit eine Hafnium-Schicht aufgedampft. Die Ausdampfgeschwindigkeit von Hafnium auf die Oberfläche des Siliciumdioxids betrug 0,3 n m je Sekunde. Die Dicke dieser Hafnium-Schicht betrug 50 n m. Anschließend wurde ein Elektronenstrahl auf eine Gold-Quelle gerichtet und das Gold damit verdampft. Das Gold wurde bis zu einer Schichtdicke von 400 n m mit einer Geschwindigkeit von 0,3 n m je Sekunde verdampft. Anschließend wurd eine zweite Schicht aus Hafnium auf der Oberseite der Goldschicht aufgedampft. Diese zweite Hafnium-Schicht wurde bis zu einer Schichtdicke von 500 nm mit einer Geschwindigkeit von 0,3 n m je Sekunde niedergeschlagen. Anschließend wurden die Proben abgekühlt, der Druck im Verdamfungsgerät an den Außendruck angeglichen und die Proben entnommen.

Anschließend wurde auf den Hafnium-Gold-Hafnium-Schichten durch photolithographische Verfahren ein Photolack-Streifenmuster mit etwa 60 Streifen je Halbleiterscheibe aufgebracht. Die Breite eines jeden Streifens betrug 5—7 $\mu$m und die Länge betrug 0,25 mm mit Kontaktflächen von 0.25 mm². Das Photolackmuster bedeckte dabei die Streifen und legte das dazwischen liegende Metall frei. Dieses freiliegende Metall wurde dann durch

Ionen-Strahl abgetragen. Anschließend wurde die Photolackmaske durch Aceton abgelöst, so daß nur die metalischen Streifen auf dem Substrat übrig blieben. Die Proben wurden dann für 16 Stunden bei 300°C angelassen. Dies hatte eine Umwandlung des metallischen Hafniums und eines Teils des Goldes in die entsprechende intermetallische Hafnium-Gold-Verbindung zur Folge. die Halbleiterscheiben wurden dann zerteilt. Jedes Halbleiterplättchen, das einen metallischen Leiterstreifen enthielt, wurde dann auf einen TO—5 Sockel aufgesetzt.

Die auf Sockeln befestigten Halbleiterplättchen mit den darauf befindlichen Leiterstreifen wurden in temperaturgeregelte Öfen eingesetzt und elektrisch an einen Mikroprozessor angeschlossen. Die Temperaturen der Atmosphäre in den Öfen wurde durch eine Rückkopplungsschaltung geregelt. Die Stromdichte in jedem Leiterstreifen wurde für den Elektromigrationstest durch den Mikroprozessor gesteuert, der auch die Ausfälle durch Elektromigration feststellte und die Ausfallzeitpunkte aufzeichnete. Der Elektromigrationstest wurde solange durchgeführt, bis mindestens zehn aus einer Gruppe von zwölf Leiterstreifen ausgefallen waren. Dabei wurden zwei Serien von je zwölf Proben untersucht, um die Reproduzierbarkeit der Prüfergebnisse sicherzustellen.

Beispiel 2

Das Verfahren nach Beispiel 1 wurde zur Erzeugung von Proben angewandt mit der Ausnahme, daß anstelle von Hafnium zur Erzeugung von Leiterstreifen, die eine Zirkon-Gold-Verbindung enthalten, Zirkon niedergeschlagen wurde. Wiederum wurden zwei Serien von zwölf Proben untersucht, um die Reproduzierbarkeit der Prüfergebnisse festzulegen.

Beispiel 3

Die zum Niederschlag der Schicht verwendeten Substrate waren Silicium-Scheiben mit einem Durchmesser von 25,4 mm, auf denen ein 500 nm dicker Überzug aus thermisch aufgewachsenem Siliciumdioxid aufgebracht war. Die Silicium-Substrate wurden in die Kammer des Verdampfungsgerätes eingebracht. Das Verdampfungsgerät wurde mit Hilfe einer mechanischen Vakuumpumpe und einer Öldiffusionspumpe für 4 Stunden zur Entgasung der Steitenwände de Verdampfungskammer augepumpt, um damit die gefahr einer Sauerstoffvergiftung während der nachfolgenden Verdampfung zu verringern. Der Kammerdruck betrug nach dem Auspumpen für 4 Stunden etwa $1,333 \times 10^{-7}$ m bar. Anschließend wurde eine Titan-Sublimationspumpe mit einem Mantel von flüssigem Stickstoff zum Absenken des Druckes auf $2,666 \times 10^{-8}$ m bar benutzt. Niob und Gold-Quellen wurden durch Elektronenstrahlen erhitzt und durch Verdampfung auf eine Blende entgast.

Niob wurde aus der Dampfphase mit einer Geschwindigkeit von 0,3 n m je Sekunde auf die Siliciumdioxid Oberfläche niedergeschlagen. Die dicke dieses Niob-Films betrug etwa 25 n m. Anschließend wurde auf die Niob-Schicht mit einer Geschwindigkeit von 0,3 n m je Sekunde eine Gold-Schicht bis zu einer Dicke von etwa 400 n m niedergeschlagen. Anschließend wurde auf der Goldschicht eine weitere Schicht aus Niob mit einer Geschwindigkeit von 0,3 n m je Sekunde bi zu einer Dicke von 25 n m niedergeschlagen. Am Ende des Verdampfungsvorgangs wurde trockener Stickstoff in die Verdampfungskammer eingeleitet und die Proben wurden entnommen.

Die verbleibenden Prüfverfahrensschritte waren die gleichen wie in Beispiel 1 und 2, und nach 9000 Stunden Prüfung wurden keine Fehler festgestellt. Zu diesem Zeitpunkt wurde Probe für eine körperliche Untersuchung entnommen, während die Prüfung der verbleibenden 11 Proben fortgesetzt wurde. Nach einer Prüfungsdauer von insgesamt 10.000 Stunden war keine der restlichen Proben ausgefallen.

Eine weiter Serie von Niob- und Gold-Strefen wurde untersucht. Diese Leiterstreifen waren schmaler als die ersten und hatten eine Breite von 2,5 $\mu$m. Die Dicke der Schichten in den Leiterstreifen war die gleiche wie in die ersten Serie. Die Schichten wurden durch Kathodenzerstäubung von Gold und Niob auf Silicium-Scheiben niedergeschlagen. Die Silicium-Scheiben hatten einen 500 n m dicken Überzug aus Siliciumdioxid. Die Silicium-Scheiben wurden in eine Kammer eingesetzt, die dann bis auf etwa $6,65 \times 10^{-8}$ m bar ausgepumpt wurde, worauf der Kammerdruck durch Einleiten von Argon in die Kammer bis auf 20 Mikron erhöht wurde. Zum Niederschlagen der Schichten wurde ein übliches Hochfrequenz-Zerstäubungsverfahren mit Vorspannung eingesetzt. Eine Hochfrequenzspannung von 1000 Volt mit einer Gleich-Vorspannung von 60 Volt wurde für den Niederschlag eines metallischen Films auf einem wassergekühlten Substrat benutzt. Die Niederschlagsgeschwindigkeiten waren für Niob 0,25 n m je Sekunde und für Gold 1,1 n m je Sekunde. Die restlichen Verfahrensschritte der Prüfung waren die gleichen wie bei der ersten Serie. Die Prüfung wurde für 2000 Stunden durchgeführt. Danach waren vier der zwölf Proben ausgefallen.

### Beispiele 4 und 5

Das Verfahren gemäß Beispiel 1 wurde zur Erzeugung von Titan-Gold-Titan und Permalloy-Gold-Permalloy-Leiterstreifen benutzt. Für die Titan-Gold-Titan-Leiterstreifen wurde nur eine Serie von Proben untersucht. Im Fall der Permalloy-Gold-Permalloy-Streifen wurden drei Serien untersucht. Für die Permalloy-Streifen, die unter etwas anderen Prüfbedingungen untersucht wurden, war es möglich, die Resultate zur Ermittlung eines Bereichs der mittleren Ausfallzeit zu interpolieren, die man erwarten könnte, hätte man dies Untersuchungen unter den gleichen Prüfbedingungen durchgeführt, wie für alle anderen Proben. Diese dem Stande der Technik entsprechenden Strukturen wurden zum Vergleich mit der Erfindung hergestellt.

### Besprechung der Ergebnisse

Die Prüfergebnisse der oben angegebenen Beispiele sind in Tabelle II zusammengefaßt, in der auch die verschiedenen Verfahrensbedingungen, Dicken der metallischen Niederschläge und und Prüfbedingungen angegeben sind.

Da bei den 6,5 $\mu$m breiten Niob-Gold-Niobstreifenleitern keine Ausfälle eintraten, zeigt Tabelle II keine mittlere Ausfallzeit für diese Streifenleiter. Die Prüfdaten zeigen jedoch, daß die mittlere Ausfallzeit jenseits von 10.000 Stunden liegen muß. Im Fall der 2,5 $\mu$m breiten Niob-Gold-Niob-Streifenleiter fielen nur 4 der 12 Proben aus. Für diese Serien von Proben wird daher eine mittlere geschätzte Ausfallzeit berichtet. Dieser Wert von 2500 Stunden liegt beträchtlich tiefer als die zu erwartende Lebensdauer bei gleichartig aufgebauten, 6,5 $\mu$m breiten Streifen. Obgleich die voraussichtliche mittlere Lebensdaure für diese beiden Serien von Niob-Gold-Niob-Streifenleitern doch unterschiedlich sind, sind die Ergebnisse miteinander verträglich. Man würde nämlich erwarten, daß feinere Leitungen empfindlicher gegen Änderungen des Verfahrens und der Prüfung wegen ihrer verringerten Querschnitte sind. Diese Änderungen können ein vorzeitiges Ausfallen zur Folge haben, wodurch sich die mittlere Lebensdauer der Proben in der Serie verringern.

Die Lebensdauerprüfungsdaten aus Tabelle II zeigen, daß die Lebensdauererwartung der aus Hafnium-Gold-Hafnium-, Zirkon-Gold-Zirkon- und Niob-Gold-Niob-Streifen (Beispiele 1—3) bestehenden Proben gegenüber dem Stand der Technik (Beispiele 4—5) beträchtlich verbessert sind. Die Lebensdauer von Hafnium-Gold-Hafnium-Leiterstreifen (Beispiel 1) wird gegenüber der Lebensdauer der Titan-Gold-Titan-Streifen (Beispiel 4) des Standes der Technik um einen Faktor zwischen 37 und 77 verbessrt. Die durch die erfindungsgemäß aufgebauter Leiterstreifen erzielte Verbesserung nimmt mit zunehmender Stabilität der gebildeten Gold-Übergangsmetall-Verbindungen zu. Bei den Niob-Gold-Niob-Leiterstreifen mit der gleichen Streifenbreite wie die Leiterstreifen des Standes der Technik beträgt die Verbesserung gegenüber den Titan-Gold-Titan-Leiterstreifen einen Faktor von mindestens 100.

Es soll darauf hingewiesen werden, daß man die Lebensdauererwartung der Leiterstreifen gemäß dem Stande der Technik um eine Größenordunung erhöhen kann, indem man wärmebehandelte Permalloy-Gold-Permalloy-Streifen benutzt. Trotzdem sind diese aus dem Stand der Technik bekannten Streifen den erfindungsgemäß aufgebauten Leiterstreifen sichtlich unterlegen. Außerdem sind diese Leiterstreifen ferromagnetisch, so daß sie nicht in Verbindung mit Magnetblasenspeichern benutzt werden können.

Die Lebensdauererwartung der Gold-Leiterstreifen gemäß der Erfindung stellt eine wesentliche Verbesserung gegenüber den aus Aluminium bestehenden Leiterstreifen gemäß der DE—A— 26 47 566.1 dar. Die Prüfdaten zeigen, daß die dünneren Streifen gemäß der Erfindung bei etwa 10% höheren absoluten Temperaturen und bei Stromdichten zu arbeiten vermögen, die um einen Faktor 2 höher liegen als im Stande der Technik, ohne daß dabei die Lebensdauererwartung der Leiterstreifen beeinträchtigt wird.

## TABELLE II

### Mittlere Ausfallzeit für Gold-Streifenleiter

Prüfbedingungen: 300 °C, 2 × 10⁻⁶ A/cm²

| Beispiel | Schicht-zusammensetzung | Dicke (nm) | Niederschlags-geschwindigkeit (0,1 nm/sec.) Serie A | Serie B | Verbindung | Leiterbreite $\mu$m | Mittlere Ausfallzeiten (Std) | Standard Abweichung |
|---|---|---|---|---|---|---|---|---|
| 1 | $\underline{Hf}$ $\underline{Au}$ $\underline{Hf}$ | $\underline{50}$ $\underline{400}$ $\underline{50}$ | $\underline{3}$ $\underline{3}$ $\underline{3}$ | $\underline{3}$ $\underline{3}$ $\underline{3}$ | $AuHf_2$, $HfAu_3$ $HfAu_5$, $HfA_2$ | 6.5 | 370 (Serie A) 770 (Serie B) | 0.16 0.21 |
| 2 | $\underline{Zr}$ $\underline{Au}$ $Zr$ | $\underline{50}$ $\underline{400}$ $50$ | $\underline{3}$ $\underline{3}$ $3$ | $\underline{3}$ $\underline{3}$ $3$ | $ZrAu_4$, $AuZr_3$, $AuZr_2$ $ZrAu_2$, $ZrAu_3$ | 6.5 | 1270 (Serie A) 3500 (Serie B) | 0.3 0.1 |
| 3 | $\underline{Nb}$ $\underline{Au}$ $Nb$ | $\underline{25}$ $\underline{400}$ $25$ | $\underline{3}$ $\underline{3}$ $3$ | $\underline{2.5}$ $\underline{11}$ $2.5$ | $Au_2Nb$, $Au_9Nb_{11}$, $Au_2Nb_3$, $AuNb_3$ | 6.5 2.5 | 10.000+ (Serie A)*** 2500* (Serie B) | — 0.3* |
| 4 | $\underline{Ti}$ $\underline{Au}$ $Ti$ | $\underline{50}$ $\underline{400}$ $50$ | $\underline{3}$ $\underline{3}$ $3$ | | $Au_6Ti$, $Au_2Ti$ $AuTi$, $AuTi_3$ | 6.5 | 10 | — |
| 5 | $\underline{Permalloy (NiFe)}$ $\underline{Au}$ $Permalloy (NiFe)$ | $\underline{50}$ $\underline{400}$ $50$ | $\underline{3}$ $\underline{3}$ $3$ | | keine | 6.5 | 100–200** | 0.3* |

* Geschätzter Wert
** Interpolierter Wert
*** Keine Ausfälle

## Patentansprüche

1. Verfahren zum Herstellen von schmalen, intermetallischen Leiterstreifen aus mindesens einer Zone eines gut leitenden Metalls und einer Zone einer intermetallischen Verbindung dieses gut leitenden Metalls durch Aufdampfen des Metalls und des Übergangsmetalls auf ein Substrat (51) in einem sauerstoff-freien Vakuum von weniger als etwa 1,333 × $10^{-5}$mbar, Anlassen dieser Schicht bei einer zwischen 200° C. und· 500° C liegenden Temperatur so lange, bis sich in der Schicht mindestens eine Zone einer Metall-Übergangsmetallverbindung gebildet hat, und Bilden der Leiterstreifen durch Maskieren und Entfernen von Teilen der Schicht, dadurch gekennzeichnet, daß auf das Substrat (51) eine Schicht (56) eines Übergangsmetalls aus der Zirkon, niob und Hafium enthaltenden Gruppe und darüber als Leiterschicht (58) eine aus Gold bestehende Schicht aufgebracht werden.

2. Verfahren nach Anspruch 1 dadurch gekennzeichnet, daß über der aus Gold bestehenden Schicht (58) mindestens eine weiter Schicht (54) aus dem Übergangsmetall aufgebracht wird.

3. Verfahren nach Anspruch 1, dadurch gekennzeichnet, daß der Niederschlag durch. Kathodenzerstäubung mit Vorspannung in einer auf eine Druck von weniger als 1,333 × $10^{-6}$ mbar ausgepumpten und dann mit einem inerten Gas bis zu einem Druck von 10—50 Mikron aufgefüllten Kammer durchgeführt wird und daß die Kathodenzerstäubung bei einer Hochfrequenzspannung zwischen etwa 500 V und 2000 V und einer Gleichvorspannung zwischen 0 V und 200 V durchgeführt wird.

4. Verfahren nach Anspruch 3, dadurch gekennzeichnet, daß die Anlaßzeit je nach Höhe der Anlaßtemperatur zwischen etwa 1 Stunde und bis zu 100 Stunden beträgt.

5. Leiterstreifen, hergestellt nach einem Verfahren gemäß einem der Ansprüche 1—4, dadurch gekennzeichnet, daß der auf einem Substrat (20, 22) liegende Leiterstreifen (10) aus Gold und mindestens einer Zone innerhalb des Leiterstreifens besteht, die eine intermetallische Verbindung aus Gold und einem Übergangsmetall aus der Niob, Zirkon und Hafnium enthaltenden Gruppe enthält.

6. Leiterstreifen nach Anspruch 5, dadurch gekennzeichnet, daß die kleinste kleiner ist als 0.015 mm.

## Revendications

1. Procédé pour fabriquer des bandes conductrices intermétalliques étroites comportant au moins une zone d'un métal bon conducteur et une zone d'un composé intermétallique de ce métal bon conducteur par dépôt en phase vapeur du métal et du métal de transition sur un substrat (51) dans un vide sans oxygène inférieur à environ 1,333 × $10^{-5}$ mbar, par recuit de cette couche à une température comprise entre 200°C et 50°C jusqu'à formation dans la couche d'au moins une zone d'un compose métal -métal de transition, et par formation des bandes conductrices á l'aide de masquage et d'enlèvement de parties de la couche, caractérisé en ce que l'on dépose sur le substrat (51) une couche (56) d'un métal de transition du groupe comprenant le zirconium, le niobium et le hafnium, et sur cette couche, une couche d'or faisant fonction de couche conductrice (58).

2. Procédé selon la revendication 1, caractérisé en ce que l'on dépose sur la couche composée d'or (58) au moins une autre couche (54) d'un métal de transition.

3. Procédé selon la revendication 1, caractérisé en ce que le dépôt est réalisé par pulvérisation cathodique avec une tension de polarisation dans une chambre mise sous vide jusqu'à une pression inférieure à 1,333 × $10^{-6}$ mbar et ensuite remplie avec un gaz inerte jusqu'à obtention d'une pression de 10 à 50 microns et en ce que la pulvérisation cathodique a lieu à une tension haute fréquence comprise entre environ 500 volts et 2000 volts et à une tension continue comprise entre 0 volt et 200 volts.

4. Procédé selon la revendication 1, caractérisé en ce que la durée de recuit est comprise entre environ 1 heure et 100 heures en fonction de la température de recuit.

5. Bandes conductrices fabriquées d'après un procédé selon l'une des revendications 1 à 4, caractérisées en ce que la bande conductrice (10) sur un substrat (20, 22) est composée d'or et d'au moins une zone dans la bande conductrice qui comporte un composé intermétallique d'or et d'un métal de transition du groupe comprenant le niobium, le zirconium et le hafnium.

6. Bande conductrice selon la revendication 5, caractérisée en ce que la largeur de bande la plus petite est inférieure à 0,015mm.

## Claims

1. A method of making a narrow, intermetallic conductive stripe having at least one zone each of a well-conducting metal and of an inter-metallic compound of this well-conductive metal with a transition metal, the method comprising depositing the well-conductive metal and the transition metal onto a substrate (51) in an oxygen-free vacuum of less than approximately 1.333 × $10^{-5}$ mbar, annealing the layer so formed at a temperature between 200°C and 500°C until at least one zone of a metal-transition compound has formed in the layer, and forming the conductive stripe by masking and removing parts of the layer, characterized in that the transition metal comprises a layer (56) of zirconium, niobium or hafnium deposited on the substrate, and the well-conductive metal comprises a layer (58) of gold deposited on the transition metal layer.

2. A method as claimed in claim 1, characterized in that at least one further layer (54) of the transition metal is deposited onto the layer (58) of gold.

3. A method as claimed in claim 1, characterized in that the deposition is effected through cathode sputtering with biasing in a chamber evacuated to a pressure of less than $1.333 \times 10^{-6}$ mbar and subsequently backfilled with an inert gas to a pressure of 10 to 50 microns, and in that the cathode sputtering is effected with a high frequency voltage between approximately 500 V and 2000 V and a bias DC-voltage between 0 V and 200 V.

4. A method as claimed in claim 3, characterized in that depending on the annealing temperature, the annealing time is between about 1 and 100 hours.

5. Conductive stripes, made in accordance with a method as claimed in any one of claims 1 to 4, characterized in that the conductive stripe (10) on a substrate (20, 22) consists of gold and of at least one zone within the conductive stripe containing an intermetallic compound of gold and a transition metal of the group containing niobium, zirconium, and hafnium.

6. Conductive stripe as claimed in claim 5, characterized in that the smallest stripe width is less than 0.015 mm.

24   10   28   26

14
18
16

20

22

12   20

**FIG. 1**

**FIG . 4**

50

52

58

54

58

51

56

57

FIG. 2

FIG. 3